(19) Europäisches Patentamt / European Patent Office / Office européen des brevets

(11) **EP 3 270 125 A1**

(12) **EUROPEAN PATENT APPLICATION**

(43) Date of publication:
**17.01.2018 Bulletin 2018/03**

(21) Application number: **16179037.3**

(22) Date of filing: **12.07.2016**

(51) Int Cl.:
*G01J 3/02* *(2006.01)*        *G01J 1/04* *(2006.01)*
*G01J 3/28* *(2006.01)*        *G01J 3/36* *(2006.01)*
*G01J 1/42* *(2006.01)*        *H01L 27/14* *(2006.01)*
*G01J 1/58* *(2006.01)*        *H01L 31/0216* *(2014.01)*
*H01L 31/0232* *(2014.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ams AG**
**8141 Unterpremstätten (AT)**

(72) Inventor: **Enenkel, Jan**
**8101 Gratkorn (AT)**

(74) Representative: **Epping - Hermann - Fischer**
**Patentanwaltsgesellschaft mbH**
**Schloßschmidstraße 5**
**80639 München (DE)**

(54) **OPTICAL SENSOR, SPECTROMETER AND METHOD FOR A SPECTROMETER**

(57)     An optical sensor (100) comprises a stack of a substrate (101), a light sensitive component (102), a light conversion layer (104), and a filter layer (105). The substrate (101) has a main surface and the light sensitive component (102) is arranged on the main surface. Furthermore, the light sensitive component (102) is sensitive to a range of wavelengths specified by a spectral response characteristic. The light conversion layer (104) is arranged on the light sensitive component (102) and comprises a conversion material. The conversion material has an excitation band and a spectrally shifted emission band. In fact, the emission band at least partially overlaps with the spectral response characteristic of the light sensitive component (102). The filter layer (105) is arranged on the light conversion layer and has a transmission characteristic which is arranged to at least partially block light incident on the optical sensor (100) having a wavelength from the range of wavelengths specified by the spectral response characteristic of the light sensitive component (102).

Figure 1

EP 3 270 125 A1

## Description

This application relates to an optical sensor, a spectrometer and to a method for a spectrometer.

Exposure to ultraviolet (UV) radiation can affect people in many different ways. Suntan, freckling and sunburn are familiar effects of over-exposure to sunlight, along with higher risk of skin cancer. Typically the exposure to UV changes during the day and there is a need for tracking such changes. Mobile devices such as Smartphones include an ever increasing amount and number of different sensors built into these devices. Measurement of UV radiation for the purpose of personal protection is one possible application for dedicated compact UV sensors.

UV sensors typically have optical components to reduce the impact or crosstalk of visible light. Often this is done by adding filters, especially by construction of narrow interference filters, to achieve a reasonable visible light rejection. However, often accurate and rather large working distances (as compared to the device heights, for example) are required for good performance. Typically, interference filters need a certain working distance in order to keep the spectral shift of their transmission characteristics low. In mobile applications, however, customers demand the device height is to be lower and lower, and, thus, working distances cannot always be realized up to their optically optimal values. Instead diffusers or dedicated optics, such as lenses, are implemented in order to avoid spectral shift of interference filters. Using diffusers, however, comes at a price. It is known that diffusers can have spectral windows in the infrared (IR). In order to achieve reasonable UV detection accuracy IR contribution to the signal has to be accounted for which cannot always be achieved to a desired level of accuracy.

It is an object of the present principle to provide an optical sensor, a spectrometer and a method for a spectrometer which is less prone to the spectral shift as discussed above.

This objective is achieved by the subject matter of the independent claims. Further developments and embodiments are described in dependent claims.

It is to be understood that any feature described in relation to any one embodiment may be used alone, or in combination with other features described, and may also be used in combination with one or more features of any other of the embodiments, or any combination of any other of the embodiments unless described as an alternative. Furthermore, equivalents and modifications not described below may also be employed without departing from the scope of the optical sensor, spectrometer and method for a spectrometer which are defined in the accompanying claims.

In one embodiment an optical sensor comprises a stack. Furthermore, the stack at least comprises a substrate, a light sensitive component, a light conversion layer and a filter layer. These components of the stack may

be directly arranged on top of each other. However, alternatively or in addition, one or more intermediate layers can be arranged between one or more of the components of the stack. By means of stacking the optical sensor has an integrated design and can be fabricated at wafer level.

The substrate, or wafer, has a main surface. For example, the substrate comprises a material such as silicon, silicon dioxide, aluminum oxide, sapphire, germanium, gallium arsenide (GaAs), an alloy of silicon and germanium, or indium phosphide (InP) and the like. The main surface serves as a foundation upon which the further components of the stack are deposited on or integrated into. The substrate may provide for additional electronic components such as terminals, a driver circuit, A/D converter, etc., i.e. generally means to operate and interface the optical sensor. The optical sensor can be integrated or fabricated in a semiconductor process at wafer level.

The light sensitive component is arranged on or in the main surface and is sensitive to a range of wavelengths of electromagnetic radiation. The sensitivity is specified by a spectral response characteristic which describes the relative efficiency of detection of electromagnetic radiation as a function of the wavelength of the signal. The light sensitive component may be a semiconductor device that converts electromagnetic radiation into a sensor signal, such as a photocurrent in case of a photodiode. The term "light" hereinafter denotes electromagnetic radiation predominantly in the visible range between wavelengths from about 390 to 700 nm. In a broader sense "light" may also include parts of the infrared, visual and/or ultraviolet (UV).

The light conversion layer is arranged on the light sensitive component. The light conversion layer and the light sensitive component may be in direct contact to each other. Alternatively or in addition an intermediate layer can be arranged between the two components. The light conversion layer comprises a conversion material having an excitation band and, with respect to the excitation band, a spectrally shifted emission band. The emission band, at least partially, overlaps with the spectral response characteristic of the light sensitive component.

The term "emission band" denotes an optical spectrum represented as a function of wavelength. This is to say that the conversion material can be excited at different excitation wavelengths as specified by a respective excitation spectrum. Similarly, the term "emission band" denotes another optical spectrum represented as a function of wavelength. Once excited at a certain excitation wavelength the conversion material may emit light at wavelengths determined by its respective emission spectrum. Typically, the emission band and excitation band are shifted in terms of wavelength with respect to each other.

The conversion material may be fluorescent, phosphorescent or luminescent material as used in fluorescent lamps or tubes, for example. In this case emission and excitation are shifted according to the materials Stokes shift. Examples include phosphor or phosphor compounds which often are used as fluorescent coatings. Preferably, the conversion material can be excited by UV light, e.g. with a quantum yield of >0.5.

However, the conversion material may also lead to fluorescence (or photon) up-conversion or the like. Examples include nanoparticles or materials that contain ions of d-block and f-block elements. Examples of these ions are $Ln^{3+}$, $Ti^{2+}$, $Ni^{2+}$, $Mo^{3+}$, $Re^{4+}$, $Os^{4+}$, and so on. Preferably, the conversion material can be excited by IR light, e.g. with a quantum yield of >0.5.

The actual choice of material may take into account the spectral properties of the light sensitive component as specified by its spectral response characteristic. After exciting the conversion material the absorbed light is shifted in wavelength by the conversion material into the range specified by the spectral response characteristic of the light sensitive component, i.e. the emission band and the spectral response characteristic overlap with a certain amount. This way the emission of the conversion layer can be detected by the light sensitive component. For example, the emission band could be chosen to overlap in the region of the spectral response characteristic indicating highest sensitivity. Thus, the light sensitive component can detect UV or IR indirectly by way of emission and detection in the visible, for example.

The filter layer is arranged on the light conversion layer, either directly or with an intermediate layer inbetween. The filter layer has a transmission characteristic which is arranged to at least partially block light incident on the optical sensor in a specified wavelength range. The range of wavelengths to be blocked by the filter layer is specified by the spectral response characteristic of the light sensitive component. Preferably, the filter layer is no interference filter as emission from the conversion material typically is diffusive and would lead to noticeable spectral shift of the filter's transmission characteristic.

During normal operation light is incident onto the optical sensor via the filter layer. The filter layer filters the incident light according to its transmission characteristic. Preferably, visible light is filtered from the incident light. After being filtered the light strikes the light conversion layer downstream the filter and eventually excites the conversion material. In particular, the absorbed incident light excites one or more excited states in the conversion material. At least one of these states stimulates emission and decays via photon emission. Depending on the specific material, emission is either shifted to longer or to shorter emission wavelengths. This is due to the impact of non-radiative states, including dynamic collisional quenching, near-field dipole-dipole interaction (or resonance energy transfer), internal conversion, and intersystem crossing, for example.

In at least one embodiment the conversion material comprises fluorescent and/or a phosphorescent material. The emission band the conversion material is shifted towards longer emission wavelengths with respect to an excitation wavelength according to a Stokes shift.

In at least one embodiment the conversion material comprises a fluorescence (or photon) up-conversion material. The emission band is shifted towards shorter emission wavelengths with respect to an excitation wavelength according to an anti-Stokes shift.

In at least one embodiment the spectral response characteristic of the light sensitive component at least partly lies in the visible and/or infrared part of the electromagnetic spectrum emission band of the conversion material at least partly lies in the visible and/or infrared part of the electromagnetic spectrum. The transmission characteristic of the filter layer is arranged to at least partly block light in the visible and/or infrared part of the electromagnetic spectrum, respectively.

In at least one embodiment the spectral response characteristic of the light sensitive component at least partly lies in the visible and/or ultraviolet part of the electromagnetic spectrum. The emission band of the conversion material at least partly lies in the visible and/or ultraviolet part of the electromagnetic spectrum. The transmission correct characteristic of the filter layer is arranged to at least partly block light in the visible and/or ultraviolet part of the electromagnetic spectrum.

In at least one embodiment an aperture layer is arranged on or near the filter layer.

In at least one embodiment the light sensitive component is a photodiode, a charge coupled device, a complementary metal oxide semiconductor optical sensor and/or an array thereof. The light sensitive component may have one or more components which can be arranged in a linear or two-dimensional array.

In at least one embodiment one or more absorption filters are arranged between the light sensitive component and the light conversion layout.

In at least one embodiment the absorption filters are organic absorption filters.

In at least one embodiment at least the light conversion layer and/or the filter layer are coated with an antireflective coating.

In summary, the proposed on-chip optical sensor may have a stack including a visible blocking filter as filter layer, to avoid that visible light can pass. This one could be an interference filter. A phosphorescent or fluorescent conversion material converts the excitation such as UV or IR light to visible light. In order to improve visible light rejection, not all light sensitive components, e.g. photodiodes, need to be covered with the conversion material, if an optical blocking barrier is not needed to avoid optical crosstalk. Absorption Filters can be used to determine in which energy band the light conversion layer has moved the excitation energy. The conversion material has diffusing emission characteristics, i.e. interference filters would be sub-ideal. Absorption filters C/R/G/B & IR could be overlaid with an organic IR blocking filter also.

In at least one embodiment a spectrometer comprises at least one optical sensor according to the principles described above. At least one further light sensitive component is arranged next to the optical sensor on a common carrier.

In at least one embodiment the at least one optical sensor and a plurality of further light sensitive components are arranged into a linear or two-dimensional array around the common center. The at least one optical sensor and the plurality of further light sensitive components are separated from each other by means of an optical light barrier to block optical crosstalk.

The further light sensitive components can be used to account for spectral contributions to sensor signal generated by the at least one optical sensor. All light sensitive components could collect different light, e.g. defined by different absorption filters. Thus, spectral information can be extracted from the spectrometer by calculating the contributions of each light sensitive component to the overall sensor signals.

In at least one embodiment the array is a rectangular or circular array.

In at least one embodiment the at least one optical sensor and the plurality of further light sensitive components each comprise at least one photodiode. Each photodiode from the plurality of further light sensitive components comprises a group of spatially separate and electrically interconnected photodiode segments. Each photodiode segment is arranged around a common center in a common first distance. The at least one optical sensor is arranged at the common center.

In at least one embodiment a method for a spectrometer according to the principles presented above comprises the following steps.

Collect a first sensor signal from the at least one optical sensor and collect a second sensor signal from the at least one further light sensitive component. As typically the first sensor signal from the optical sensor has components of other spectral regions compensate the contribution of the second sensor signal from the first sensor signal. Finally, provide the compensated first sensor signal.

The proposed principle allows for up to 4x more light sensitivity compare to regular sensor using a UV filter in combination with a high quality diffusor. The setup even allows for 10x more sensor signal compared to a the performance possible with a common filter / diffusor combination. As more spectral information can be recorded the spectral contribution of different color channels enables the option to separate between spectral bands such as UV-A, UV-B and UV-C. Higher spectral accuracy can be achieved because of the possibility to use a plurality of photodiodes to compensate for production tolerances. This renders the sensor signal mostly independent from the fluorescent material. Compensation of fluorescent material tolerances is also possible. The conversion materials makes the system less independent on temperature, for example a NWELL can shift to up to 25% at 300 nm at 50°C, conversion materials do not shift considerably under changing temperature and are more stable at 400 to 700 nm. The optical stack build-up can be kept rather flat because smaller working distances are necessary when compared to common interference filters setups. Furthermore, a higher angular independence can be achieved in arrays arrangements and no diffusor is needed.

In the following, the principle presented above is described in further detail with respect to drawings, in which exemplary embodiments are presented.

Figure 1 shows an exemplary embodiment of an optical sensor

Figure 2 an exemplary embodiment of another optical sensor.

Figure 3 an exemplary embodiment of another optical sensor.

Figure 4 shows an exemplary embodiment of a spectrometer.

Figure 5 shows another exemplary embodiment of a spectrometer.

Figure 6 shows spectral response characteristics for several photodiodes.

Figure 7 shows spectral response characteristics for several photodiodes.

Figure 8 shows an exemplary measurement of UV light with a spectrometer according to the principle presented.

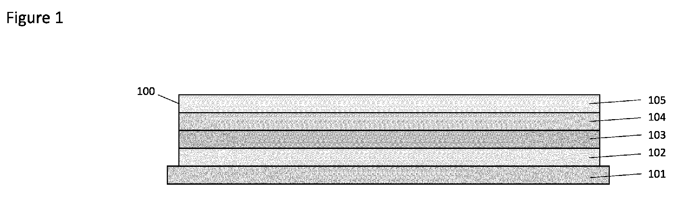

Figure 1 shows an exemplary embodiment of an optical sensor. Depicted in Figure 1 is an example of a single optical sensor 100 comprising an on-chip stack up. The stack comprises a substrate 101, a light sensitive component 102, a color filter 103, a light conversion layer 104, and a filter layer 105. These components are stacked onto one another in a wafer level process. Generally, intermediate layers, such as adhesion or passivation layers may be present but are not depicted in the drawing for easier representation. However, the components of the stack can also be stacked directly onto one another, i.e. with a direct contact of their respective surfaces.

In a certain sense the substrate 101 constitutes the foundation upon which the further components of the stack are distributed on. Preferably, the substrate comprises a semiconductor material so that the optical sensor can be fabricated at wafer level. Furthermore, not shown in the drawing, the substrate comprises additional electrical components such as terminals in order to operate and interface the optical sensor. As depicted in the drawing the substrate 101 may protrude from the rest of the stack to form space for terminals such as contacts. However, the substrate may also be flush with the rest of the stack and provide through-substrate vias or bumps on its backside for electrical contacting.

In this particular embodiment the light sensitive component 102 is a single photodiode. The photodiode is arranged on a main surface of the substrate 101 and may span along the entire width of the stack or along at least parts of it. Preferably, the photodiode is sensitive to visible light as specified by its spectral response characteristic. The spectral response characteristic defines a ratio of generated photocurrent to incident light power. Preferably, the maximum sensitivity of the photodiode lies in the visible part of the spectrum. However, typically the photodiode is also sensitive to IR and/or UV light. Typically, the photodiode is electrically connected with the substrate. This way the photodiode can be operated, e.g. by collecting sensor signal due to incident light.

The color filter 103 is an optional component and preferably is arranged on the light sensitive component 102. Preferably the color filter 103 is an absorption filter having a certain transmission characteristic which overlaps with the spectral response characteristic of the light sensitive component 102. For example, the color filter 103 is an organic filter or an absorption filter with an organic coating. Depending on material properties of the light conversion layer 104 it is further preferred that the color filter 103 is not an interference filter as this type of filter would cause spectral shift under larger angles of incidence, for example. Organic color filters may comprise layers of transmissive and/or absorptive organic or pigment dyes.

The light conversion layer 104 is arranged on the color filter 103 and comprises a conversion material. The conversion material can be excited at various excitation wavelengths as defined by its excitation band. Furthermore, the conversion material has an emission band which, in terms of wavelengths, is shifted with respect to its corresponding excitation band. The actual shift depends on the specific material chosen to be implemented into the light conversion layer 104.

Fluorescent and/or phosphorescent materials shift emission towards longer wavelength as specified by their Stokes shift. Examples include phosphor or phosphor compounds often used as coatings in fluorescent lamps to convert UV excitation into visible light. However, fluorescence (or photon) up-conversion materials can be used as conversion material as well. Such materials shift emission towards shorter wavelengths as specified by their anti-Stokes shift. Examples include certain nanoparticles and/or materials that contain ions of d-block and f-block elements such as $Ln^{3+}$, $Ti^{2+}$, $Ni^{2+}$, $Mo^{3+}$, $Re^{4+}$, $Os^{4+}$, and so on.

As a constraint the conversion material is chosen to have an emission band which at least partially overlaps with the spectral response characteristic of the light sensitive component 102. In a certain sense the light conversion layer 104 converts incident light by way of the conversion material into an emission that can be detected by the light sensitive component 102. If excitation is in the UV range than a UV sensor can be implemented. If, however, excitation lies in the IR then an IR detector can be realized (further details will be discussed below).

The filter layer 105 is arranged on the light conversion layer. Generally, the filter layer can be arranged below or above the light conversion layer 104 (as seen from a direction facing away the main surface of the substrate 101). If, filter layer 105 is arranged above the light conversion layer 104 then it may be implemented as an interference filter. If, however, filter layer 105 is arranged below the light conversion layer 104 then it is preferred that the filter layer 105 is no interference filter. In any case a transmission characteristic of the filter layer 105 is arranged to at least partially block light which is incident on the optical sensor with a wavelength that lies in the range of wavelengths specified by the spectral response characteristic of the light sensitive component. This way direct detection of incident light which is not shifted by means of the light conversion layer 104 is effectively reduced or even prevented.

Under normal operation light is incident onto the optical sensor 100 via the filter layer 105. The filter layer 105 filters the incident light according to its transmission characteristic. For example, visible light is filtered from the incident light. After being filtered the light enters the light conversion layer 104 and excites the conversion material. The absorbed incident light excites one or more excited states in the conversion material. At least one of these states decays via photon emission. Depending on the specific material emission is either shifted to longer or to shorter emission wavelengths. This is due to the impact of non-radiative states, including dynamic collisional quenching, near-field dipole-dipole interaction (or resonance energy transfer), internal conversion, and intersystem crossing, for example.

The light emitted from the light conversion layer 104 then passes through the color filter 103 and gets filtered again. The color filter 103 allows to determine a spectral band into which the incident light has been converted by means of the light conversion layer 104 and, thus, can be used for spectroscopic applications. Finally, the emitted and color filtered light strikes the light sensitive component and generates a corresponding sensor signal. The sensor signal can be collected from the light sensitive component and further processed by signal processing means which are either integrated into the same optical sensor, for example, arranged on the same substrate, or is provided at external means by way of the electrical connections to the optical sensor.

The sensor signal generated by the optical sensor is an indication of the incident light before being converted and filtered by the optical sensor. Appropriate calibration of the optical sensor thus allows for extracting spectroscopic or spectral information from the sensor signal. For example, if for the incident light predominantly is ultraviolet radiation than the sensor signal is an indication of incident UV light and the sensor can be considered a UV sensor. On the contrary, if the incident light predominantly is infrared radiation than the sensor signal is an indication of incident infrared light and the sensor can be considered an infrared sensor. It is to be understood that the spectral sensitivity of the overall optical sensor can be fine-tuned and adapted in view of the specific application at hand.

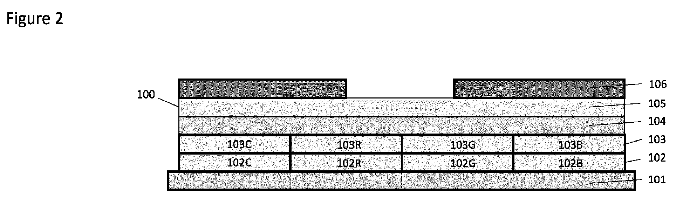

Figure 2 shows an exemplary embodiment of another optical sensor. Basically, the optical sensor shown in Figure 2 is based on the one shown with respect to figure 1. However, and aperture layer 106 is distributed on a surface of filter layer 105. The aperture layer 106 constitutes the first component for incident light to pass on its way to the light sensitive component 102.

Further differences relate to the color filter 103 and the light sensitive component 102. The color filter 103 comprises several filters which differ from each other by having different transmission characteristics. For example, a first color filter 103C (or "clear" filter) has a broad transmission for several wavelengths or colors. A second color filter 103R (or "red" filter) has a more narrow transmission in the red part of the visible spectrum. A third color filter 103G (or "green" filter) has a more narrow transmission in the green part of the visible spectrum. A fourth color filter 103B (or "blue" filter) has a more narrow transmission in the blue part of the visible spectrum. The filters 103C, 103R, 103G, and 103B are arrange together to form the color filter 103.

In correspondence to the filters 103C, 103R, 103G, and 103B also the light sensitive component 102 is arranged in separate units such as individual photodiodes. For example, a first photodiode 104C is arranged below the first filter 103C. A second photodiode 104R is arranged below the second filter 103R. A third photodiode 104G is arranged below the third filter 103G. A fourth photodiode 104B is arranged below the fourth filter 103B. The photodiodes can be arranged on the same substrate 101, i.e. a common carrier. Alternatively, the photodiodes and filters can be arranged on separate substrates 101 (as illustrated by dashed lines in the drawing) effectively forming separate optical sensors which can be closely arranged with respect to each other.

The proposed design with several light sensitive components and corresponding filters with dedicated transmission characteristics allows to spectrally separate light induced sensor signals. This design is especially adapted to spectroscopy and spectral signal acquisition.

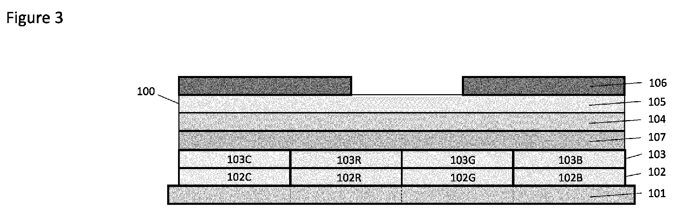

Figure 3 shows an exemplary embodiment of another optical sensor. The optical sensor shown in the drawing only differs from the one depicted in Figure 2 in that an infrared absorption filter is arranged between the color filters 103 and the light conversion layer 104. The infrared absorption filter may be an organic or organic coated absorption filter. The infrared absorption filter is used to reject non-visible light such as infrared or UV, for example.

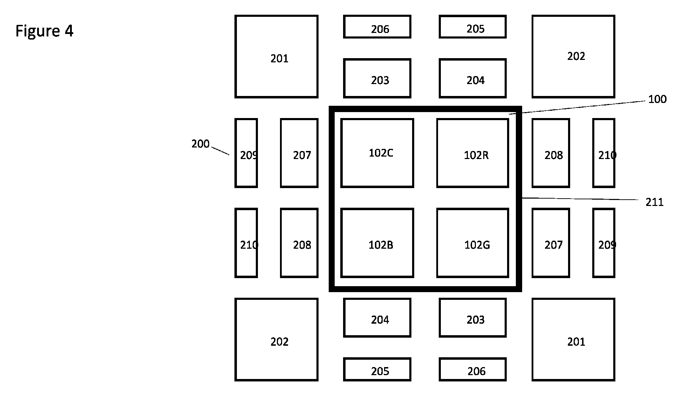

Figure 4 shows an exemplary embodiment of a spectrometer. The optical sensors 100 presented above can be embedded into a spectrometer in several different ways. As an example, the drawing shows a rectangular array 200 including an optical sensor according to the principles derived above and several more photodiodes are arranged in a matrix manner around a common center of symmetry and on a common carrier (not shown).

The optical sensor 100 is centered in the common center of the matrix arrangement and is separated from the remaining photodiodes in the array by means of an optical barrier 211. The optical barrier extends with a certain height from the main surface of the common carrier and is arranged to reduce crosstalk between the optical sensor and the remaining photodiodes in the array.

The optical sensor 100 is surrounded by the optical barrier 211 and is based on the principles derived with respect to Figures 1 to 3. This is to say that the optical sensor 100 comprised the proposed stack of layers including the light conversion layer, for example, according to one or more embodiments discussed above. However, the photodiodes 102C, 102R, 102G, 102B of the optical sensor are not arranged along a single line, as depicted in Figures 1 to 3, but rather in a rectangular 2x2 matrix fashion. In other embodiments (not shown) the optical sensor 100 may employ a different arrangement of photodiodes along any one embodiment presented herein.

Furthermore, additional light barriers can be distributed between the photodiodes of the optical sensor 100 if necessary. Typically, crosstalk between these photodiodes is already reduced because of the filter layer embedded in the optical sensor.

Several photodiodes are distributed around the optical sensor 100 but do not comprise the layered stack-up design proposed above. Basically, these photodiodes are arranged in pairs and at constant distances with respect to the common center of the array. Within a given pair of photodiode comprises at least two or more segments which are electrically interconnected to effectively form a single, larger photodiode. For example, photodiode pair 201 is arranged in the upper left corner of the array and also in the lower right corner at the same distance with respect to the common center of the array. These two components form just a single photodiode so that photodiodes 201 can be considered a segment of this larger photodiode. Following the same principle the array also comprises photodiode pairs 202, 203, 204, 205, 206, 207, 209, and 210.

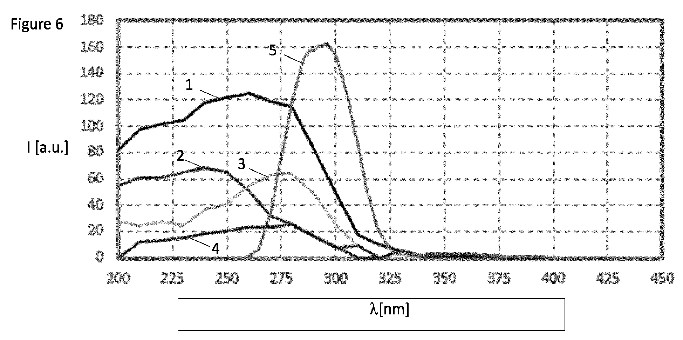

The segments from a given photodiode pair preferably have the same shape and are matched in their properties. Photodiodes from different pairs, however, do not necessarily have to be matched but may comprise different areas, shape and electrical properties, such as different sensitivity or spectral response characteristics. All photodiodes in the spectrometer array are electrically interconnected so that their respective photocurrent's or sensor signals can individually be collected and provided to a sensor signal processing unit for spectral analysis. Further details will be discussed with respect to Figures 6 to 8.

The matrix-like arrangement of photodiodes in the spectrometer sensor is less prone to changing illumination with light incident from different angles. This is to say that light incident under certain angle may reach at least one of the photodiode segments in a given pair independent of the direction of the incident light. As all the segments in a pair contribute to a photodiode's signal.

Preferably, in a spectrometer application the different photodiodes can be attributed as channels with different spectral characteristics. For example, the photodiodes of the optical sensor 100 are indicative of wavelengths which excite the conversion material in the light conversion layer. In one example, the optical sensor 100 is excited by UV light and, thus, gives an indication and spectral information of the incident UV light. The remaining photodiodes may be provided with a respective color filter and, thus, collect an indication and spectral information according to their color filter transmission characteristics. This information can be used to account for spectral contributions to the sensor signals of the optical sensor 100 and can be compensated for.

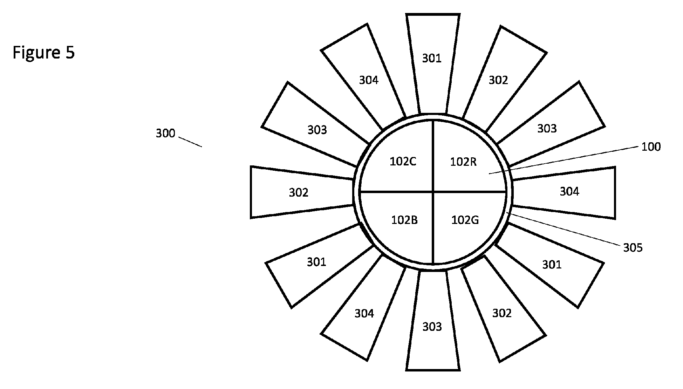

Figure 5 shows another exemplary embodiment of a spectrometer. The spectrometer comprises a circular array 300 including an optical sensor 100 according to the principles derived above and several more photodiodes are arranged in a circular manner around a common center of symmetry and on a common carrier (not shown). The optical sensor 100 is centered in the center of the circular arrangement and separated from the remaining photodiodes in the array by means of an optical barrier 305.

The optical barrier 305 extends with a certain height from the main surface of the common carrier and is arranged to reduce crosstalk between the optical sensor and the remaining photodiodes in the array. The optical sensor 100 within the boundaries of optical barrier 305 is based on the principles derived with respect to Figures 1 to 3. This is to say that the proposed stack of layers including the light conversion layer, for example, according to one or more embodiments discussed above.

However, the photodiodes 102C, 102R, 102G, 102B of the optical sensor are not arranged along a single line, as depicted in Figures 1 to 3, or in a rectangular matrix as shown in Figure 4, but rather in a circular fashion. In other embodiments (not shown) the optical sensor may employ a different arrangement of photodiodes along any one embodiment presented herein. For example, the center optical sensor 100 could also be arranged in a rectangular matrix fashion. Furthermore, additional light barriers can be distributed between the photodiodes of the optical sensor 100, if necessary. Typically, crosstalk between these photodiodes is already reduced because of the filter layer embedded in the optical sensor 100.

Several photodiodes are distributed around the optical sensor 100 but do not comprise the layered stack-up design of the optical sensor 100. Basically, these photodiodes are arranged in groups at constant distances with respect to the common center of the array. A given group of photodiodes comprises at least two or more segments which are electrically interconnected to effectively form a single, larger photodiode. For example, each segment of photodiode group 301 is arranged at the same distance with respect to the common center of the array. The photodiode group 301 can be considered a single photodiode. Following the same principle the array also comprises photodiode groups 302, 303, and 304, for example.

The segments from a given photodiode group preferably have the same shape and are matched in their properties. Further groups of photodiodes may be implemented into the array, for example, arranged in rings around the common center, and do not necessarily have to be matched. Rather those photodiodes may comprise different areas and electrical properties, such as different sensitivity or spectral response characteristics. All photodiodes in the spectrometer array are electrically interconnected so that their respective photocurrents of sensor signals can be collected and provided to a sensor signal processing unit for spectral analysis. Further details will be discussed with respect to Figures 6 to 8.

Sub-dividing the photodiodes into groups and distributing them in a radial, common centroid arrangement reduces illuminance shifting, i.e. dependence of photodiode exposure on angular irradiance. For example, photodiode area illuminance increases in one sub-divided photodiode segment while decreasing in radially arranged other sub-divided photodiode segment from the same group, resulting in a smaller net change due to angle of irradiance. Photodiode sensing can be improved as sensor sensitivity is less prone to radiance source angle.

Figure 6 shows spectral response characteristics for several photodiodes. Wavelengths $\lambda$ are depicted on the X axis in units of nm, intensities I are depicted on the Y axis in arbitrary units. The graph shows response curves of clear 1, red 2, green 3, and blue 4 filtered photodiodes with an overlaid conversion material according to the principles discussed above. Additionally, a regular UV filter has been overlaid with similar gain settings. The spectral response of the photodiode with this UV filter is shown by reference numeral 5. No diffuser is added at the UV filter. The graph shows some sensitivity of the filtered photodiodes in the ultraviolet range of the electromagnetic spectrum. However, sensitivity is typically lower than compared to the setup with the UV filter only, i.e. without any conversion material present. There's almost no sensitivity above 350 nm to 450 nm.

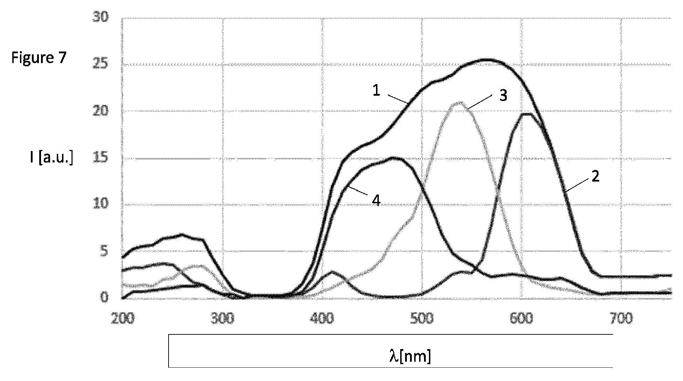

Figure 7 shows spectral response characteristics for several photodiodes. Wavelengths $\lambda$ are depicted on the X axis in units of not only to his, intensities I are depicted on the Y axis in arbitrary units. The graph shows response curves of clear 1, red 2, green 3, and blue 4 filtered photodiodes with an overlaid conversion material according to the principles discussed above. However, with respect to the graph of figure 6 the spectral scan has been extended from 200 nm to 750 nm. The same conversion material has been used at low gain settings. They are working distance has been applied.

In this representation it is apparent that direct excitation of UV between 200 and 300 nm is less sensitive than in direct excitation by means of the conversion material between about 400 to 700 nm. This proof of principle measurement shows that UV excitation radiation can be detected indirectly in the visible range after being converted by the light conversion layer into visible emission.

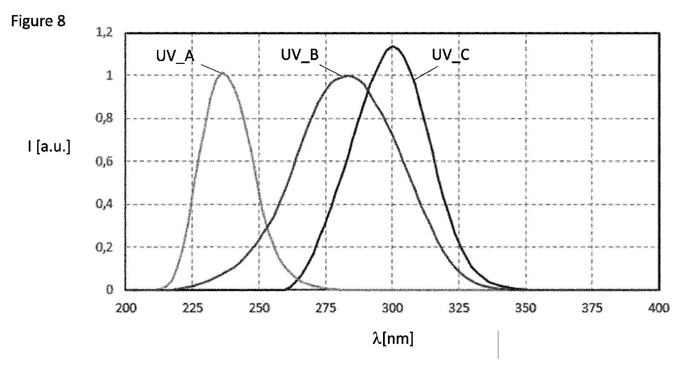

Figure 8 shows an exemplary measurement of UV light with a spectrometer according to the principle presented. Wavelengths $\lambda$ are depicted on the X axis in units of not only to his, intensities I are depicted on the Y axis in arbitrary units. A spectral analysis methodology will be explained hereinafter based on the radial sensor of Figure 6. The methodology, however, can be applied to any of the sensors discussed herein. In this particular example the spectroscopic sensor is arranged to detect UV light by choosing a conversion material that spectrally shifts UV excitation into visible emission.

The spectroscopic sensor basically has 8 light sensitive elements. From the optical sensor 100 photodiodes 102C, 102R, 102G, 102B collect sensor signals *S1, S2, S3,* and *S4*, respectively. The groups of photodiodes 301, 302, 303, and 304 collect sensor signals *S5, S6,* S7, and *S8,* respectively. From these signals the following matrix equation can be established (for example, by means of signal processing unit):

$$\begin{bmatrix} UV\_A \\ UV\_B \\ UV\_C \end{bmatrix} = [3x8] \cdot \begin{bmatrix} S1 \\ S2 \\ S3 \\ S4 \\ S5 \\ S6 \\ S7 \\ S8 \end{bmatrix},$$

wherein *UV_A, UV_B,* and *UV_C* denote UVA, UVB, UVC spectral bands, respectively. The term [3x8] denotes a calibration matrix whose values can be derived using spectral reference measurements, for example with standard discharge lamps.

The calculation results in an estimation of the UVA, UVB, and UVC spectral bands. By way of the matrix calculation the spectral response of photodiodes without conversion material are implicitly accounted for. The contribution of crosstalk and spectral shift of filters etc. can effectively be reduced. The calculation matrix and the combination of UV sensitive units & visible light units helps to reduce the effect of visible light in the UV sensors which is an accuarcy issue in current applications. Additionally to this sensor signals *S5, S6,* S7, and *S8* could be used for regular ambient light applications. As no extra UV-Filter is used on the photodiodes this concept would improve the angular performance because no more interference filters are needed in the application.

Reference numerals

| | |
|---|---|
| 1 | clear |
| 2 | red |
| 3 | green |
| 4 | blue |
| 5 | UV filter |
| 100 | optical sensor |
| 101 | substrate |
| 102 | light sensitive component |
| 102C | clear photodiode |
| 102R | red photodiode |
| 102G | green photodiode |
| 102B | blue photodiode |
| 103 | color filter |
| 103C | clear filter |
| 103R | red filter |
| 103G | green filter |
| 103B | blue filter |
| 104 | light conversion layer |
| 105 | filter layer |
| 106 | aperture layer |
| 107 | absorption filter layer |
| 200 | spectrometer |
| 201 - 210 | photodiode segment or group |
| 211 | optical light barrier |
| 300 | spectrometer |
| 301 - 304 | photodiode segment or group |
| 305 | optical light barrier |
| UV_A | spectral band |
| UV_B | spectral band |
| UV_C | spectral band |

**Claims**

**1.** Optical sensor (100), comprising a stack of:

- a substrate (101) having a main surface,
- a light sensitive component (102) arranged on the main surface and being sensitive to a range of wavelengths specified by a spectral response characteristic,
- a light conversion layer (104) arranged on the light sensitive component (102) and comprising a conversion material having an excitation band and a spectrally shifted emission band, wherein the emission band at least partially overlaps with the spectral response characteristic of the light sensitive component (102), and

- a filter layer (105) arranged on the light conversion layer and having a transmission characteristic which is arranged to at least partially block light incident on the optical sensor (100) having a wavelength from the range of wavelengths specified by the spectral response characteristic of the light sensitive component (102).

2. Optical sensor according to claim 1, wherein

- the conversion material comprises a fluorescent and/or phosphorescent material, and
- the emission band is shifted towards longer emission wavelengths with respect to an excitation wavelength according to a Stokes shift.

3. Optical sensor according to claim 1, wherein

- the conversion material comprises a fluorescence up conversion material, and
- the emission band is shifted towards shorter emission wavelengths with respect to an excitation wavelength according to an Anti-Stokes shift.

4. Optical sensor according to one of claims 1 to 3, wherein

- the spectral response characteristic of the light sensitive component (102) at least partly lies in the visible and/or infrared part of the electromagnetic spectrum,
- the emission band of the conversion material at least partly lies in the visible and/or infrared part of the electromagnetic spectrum, and
- the transmission characteristic of the filter layer is arranged to at least partly block light in the visible and/or infrared part of the electromagnetic spectrum.

5. Optical sensor according to one of claims 1 to 3, wherein

- the spectral response characteristic of the light sensitive component (102) at least partly lies in the visible and/or ultra violet part of the electromagnetic spectrum,
- the emission band of the conversion material at least partly lies in the visible and/or ultra violet part of the electromagnetic spectrum, and
- the transmission characteristic of the filter layer is arranged to at least partly block light in the visible and/or ultra violet part of the electromagnetic spectrum.

6. Optical sensor according to one of claims 1 to 5, wherein an aperture layer (106) is arranged on or near the filter layer (105).

7. Optical sensor according to one of claims 1 to 6, wherein the light sensitive component is a photodiode, a charge coupled device, a complementary metal oxide semiconductor optical sensor and/or an array thereof.

8. Optical sensor according to one of claims 1 to 7, wherein one or more absorption filters (103) are arranged between the light sensitive component (102) and the light conversion layer (104).

9. Optical according to one of claims 1 to 8, wherein an infrared absorption filter (107) is arranged between the light sensitive component (102) and the light conversion layer (104).

10. Optical according to claim 8, wherein the absorption filters (103) are organic absorption filters.

11. Optical according to one of claims 1 to 10, wherein at least the light conversion layer (102) and/or the filter layer (105) are coated with an antireflective coating.

12. Spectrometer, comprising:

- at least one optical sensor (100) according to one of claims 1 to 11, and
- at least one further light sensitive component arranged next to the optical sensor (100) on a common carrier.

13. Spectrometer according to claim 12, wherein

- the at least one optical sensor (100) and a plurality of further light sensitive components are arranged into an array around a common center, and
- the at least one optical sensor (100) and the plurality of further light sensitive components are separated from each other by means of an optical light barrier (211, 305).

14. Spectrometer according to claim 13, wherein the array is a rectangular or circular array.

15. Spectrometer according to claims 12 or 13, wherein

- the at least one optical sensor (100) and the plurality of further light sensitive components each comprise at least one photodiode,
- each photodiode from the plurality of further light sensitive components comprises a set of spatially separate and electrically interconnected photodiode segments,
- each photodiode segment is arranged around the common center in a common first distance, and

- the at least one optical sensor (100) is arranged at the common center.

16. Method for a spectrometer according to one of claims 12 to 15, comprising the steps of:

- collecting a first sensor signal from the at least one optical sensor (100),
- collecting a second sensor signal from the at least one further light sensitive component,
- compensate the contribution of the second sensor signal from the first sensor signal, and
- provide the compensated first sensor signal.

Figure 1

Figure 2

Figure 3

Figure 4

Figure 5

Figure 6

Figure 7

Figure 8

Europäisches
Patentamt

European
Patent Office

Office européen
des brevets

**EUROPEAN SEARCH REPORT**

Application Number

EP 16 17 9037

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/187426 A1 (YOUNG NIGEL DAVID [GB] ET AL) 29 July 2010 (2010-07-29) * abstract; figure 9a * | 1-11 | INV. G01J3/02 G01J1/04 G01J3/28 |
| X | WO 2008/021444 A2 (INTEMATIX CORP [US]; LI YI-QUN [US]; CHENG SHIFAN [US]; RYDE MAGNUS [U) 21 February 2008 (2008-02-21) * abstract; figure 3 * | 1-7,11 | G01J3/36 G01J1/42 H01L27/14 G01J1/58 |
| X | WO 00/74140 A1 (INTEL CORP [US]; BOOTH LAWRENCE A JR [US]) 7 December 2000 (2000-12-07) * abstract; figure 5 * | 1-7,11 | H01L31/0216 H01L31/0232 |
| X | EP 2 455 732 A1 (RAYTHEON CO [US]) 23 May 2012 (2012-05-23) * abstract; figure 1 * | 1-7,11 | |
| X | US 5 446 286 A (BHARGAVA RAMESHWAR N [US]) 29 August 1995 (1995-08-29) * abstract; figure 11 * | 1-7,11 | |
| A | EP 1 199 886 A1 (APPLIED SCINTILLATION TECHNOLO [GB]) 24 April 2002 (2002-04-24) * abstract * | 3 | TECHNICAL FIELDS SEARCHED (IPC) G01J H01L |

~~The present search report has been drawn up for all claims~~

| Place of search | Date of completion of the search | Examiner |
|---|---|---|
| Munich | 13 January 2017 | Schmidt, Charlotte |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-11

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 16 17 9037

The Search Division considers that the present European patent application does not comply with the
requirements of unity of invention and relates to several inventions or groups of inventions, namely:

1. claims: 1-11

an optical sensor using up/down conversion material,
absorption filters and specific blocking filters. This is
directed to the problem of filter and conversion material
adaptation to provide the required spectral response.
---

2. claims: 12-16

a spectrometer comprising an optical sensor and at least one
further, preferably a plurality of further light sensitive
components separated by an optical light barrier and
arranged around a common center. This is directed to the
problem of reducing cross talk by the barrier and providing
a sensor less sensitive to variations in the angle of
incidence by using pairs of separated components.
---

## ANNEX TO THE EUROPEAN SEARCH REPORT
## ON EUROPEAN PATENT APPLICATION NO.

EP 16 17 9037

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2017

| Patent document cited in search report | | Publication date | Patent family member(s) | | Publication date |
|---|---|---|---|---|---|
| US 2010187426 | A1 | 29-07-2010 | CN<br>TW<br>US | 101788338 A<br>201028671 A<br>2010187426 A1 | 28-07-2010<br>01-08-2010<br>29-07-2010 |
| WO 2008021444 | A2 | 21-02-2008 | TW<br>US<br>WO | 200818479 A<br>2008043129 A1<br>2008021444 A2 | 16-04-2008<br>21-02-2008<br>21-02-2008 |
| WO 0074140 | A1 | 07-12-2000 | AU<br>CA<br>DE<br>EP<br>JP<br>JP<br>TW<br>US<br>WO | 4857200 A<br>2373595 A1<br>60035586 T2<br>1183733 A1<br>4426139 B2<br>2003529955 A<br>492256 B<br>2003133029 A1<br>0074140 A1 | 18-12-2000<br>07-12-2000<br>17-04-2008<br>06-03-2002<br>03-03-2010<br>07-10-2003<br>21-06-2002<br>17-07-2003<br>07-12-2000 |
| EP 2455732 | A1 | 23-05-2012 | EP<br>IL<br>US | 2455732 A1<br>216152 A<br>2012126354 A1 | 23-05-2012<br>30-07-2015<br>24-05-2012 |
| US 5446286 | A | 29-08-1995 | NONE | | |
| EP 1199886 | A1 | 24-04-2002 | AT<br>DE<br>DE<br>EP<br>US | 261640 T<br>60008877 D1<br>60008877 T2<br>1199886 A1<br>2002044781 A1 | 15-03-2004<br>15-04-2004<br>03-03-2005<br>24-04-2002<br>18-04-2002 |

EPO FORM P0459

For more details about this annex : see Official Journal of the European Patent Office, No. 12/82